# EUROPEAN PATENT SPECIFICATION

(11) **EP 2 842 797 B1**
(45) Date of publication and mention of the grant of the patent: **23.10.2019**
(21) Application number: 14182963.0
(22) Date of filing: 29.08.2014
(51) Int. Cl.: H01R 13/115, H01R 13/24, H01R 4/48, H01R 11/12, H01R 11/05, H01R 13/20, H01M 2/20, H01M 10/48, H01R 11/28, H01M 10/6555, H01M 10/613

(54) **Battery pack**
Batteriepack
Bloc-batteries

(30) Priority: 30.08.2013 KR 20130104500
(43) Date of publication of application: 04.03.2015
(73) Proprietor: Samsung SDI Co., Ltd., Yongin-si, Gyeonggi-do (KR)
(72) Inventor: Noh, Kyoung-Hwan, Gyeonggi-do (KR); Bae, Min-Cheol, Gyeonggi-do (KR)
(74) Representative: Mounteney, Simon James

(56) References cited:
- WO-A1-2006/048625
- WO-A1-2012/137289
- US-A- 2 552 392
- US-A1- 2012 323 511
- US-B1- 6 346 011

## Description

### BACKGROUND

### 1. Field

The invention relates to a battery pack.

### 2. Description of the Related Art

Unlike primary batteries, secondary batteries are rechargeable. Secondary batteries are used as energy sources of devices such as mobile devices, electric vehicles, hybrid electric vehicles, electric bicycles, and uninterruptible power supplies. Single-cell secondary batteries or multi-cell secondary batteries (secondary battery packs), in which a plurality of cells are connected, are used according to the types of external devices using the secondary batteries.

Small mobile devices, e.g., cellular phones, may be operated for a certain period of time using single-cell secondary batteries. Battery packs having high-output, high-capacity features may be suitable for devices having long operating times and consuming large amounts of power, e.g., electric vehicles and hybrid electric vehicles. The output voltages or currents of the battery packs may be increased by adjusting the number of battery cells included in the battery packs.

Battery packs may include terminals to measure state variables, e.g., temperatures and voltages of the battery cells, for detecting abnormal operations, e.g., overheating, overcharging, and over-discharging, and for controlling charging and discharging operations of the battery packs. Document US6346011 discloses a battery pack comprising a plurality of battery cells connected by bus bars 16. The bus bar is additionally provided with a voltage detection terminal 17, which is mounted on the bus bar. Document WO2006048625 discloses a battery with a connection means to measure an electrical parameter and a temperature of the battery. The connectors are of the push fit type.

The present invention sets out to provide an improved structure for the application of such terminals so as to optimise performance and simplify manufacture.

### SUMMARY

According to the invention, there is provided a battery pack as set-out in Claim 1. Optional features of the invention are set-out in Claims 2 to 18.

### BRIEF DESCRIPTION OF THE DRAWINGS

Features of the invention will be made more apparent to those of ordinary skill in the art by describing in detail embodiments of the invention with reference to the attached drawings, in which:
FIG. 1 illustrates an exploded perspective view of a battery pack according to an embodiment of the invention;
FIG. 2 illustrates a perspective view of an arrangement of the battery cells depicted in FIG. 1;
FIG. 3 illustrates a perspective view of how first and second sensing terminals are connected to the battery cells to measure temperatures and voltages of the battery cells;
Fig. 4 illustrates an enlarged view of a portion of FIG. 3;
FIGS. 5A and 5B illustrate perspective views of connection structures of the first and second sensing terminals;
FIGS. 6A and 6B illustrate cross-sectional views along line VI-VI of FIGS. 5A and 5B, respectively;
FIG. 7 illustrates a plan view of the second sensing terminal; and
FIG. 8 illustrates a perspective view of connection structures of first and second sensing terminals as comparative examples.

### DETAILED DESCRIPTION

Reference will now be made in detail to embodiments of the invention, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of implementations of the invention. As used herein, the term "and/or" includes any and all combinations of one or more of the associated listed items. Expressions such as "at least one of," when preceding a list of elements, modify the entire list of elements and do not modify the individual elements of the list.

A battery pack will now be described in detail with reference to the accompanying drawings.

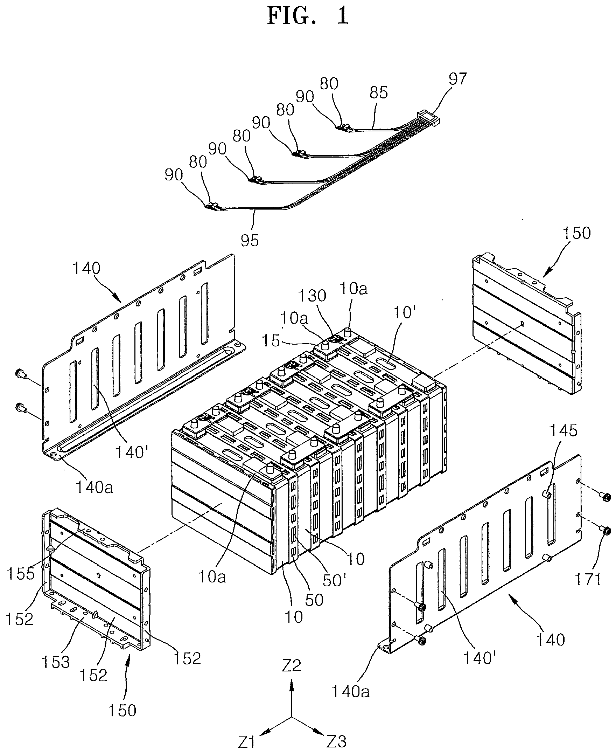

FIG. 1 illustrates an exploded perspective view of a battery pack according to an embodiment of the invention. Referring to FIG. 1, the battery pack may include a plurality of battery cells 10 arranged in an arrangement direction Z1, and side plates 140 and end plates 150 surrounding the battery cells 10. The battery pack may further include wires 85 and 95 arranged above the battery cells 10.

The wires 85 and 95 may include temperature measuring wires 85 and voltage measuring wires 95 extending from first and second sensing terminals 80 and 90 connected to connectors 130 formed on bus bars 15. Information about states of the battery cells 10 obtained through the wires 85 and 95 may include a temperature measuring signal and a voltage measuring signal. Such state information of the battery cells 10 is transmitted to a battery management system (BMS) (not shown) for detecting abnormal operations of the battery cells 10, e.g., overheating, overcharging, and over-discharging, and for monitoring charging and discharging states, e.g., a fully-charged state of the battery cells 10. For example, the temperature measuring wires 85 and the voltage measuring wires 95 may extend to a connection part 97 from the first and second sensing terminals 80 and 90 configured to be connected to the connectors 130. The connection part 97 may be connected to a circuit board (not shown) functioning as a BMS.

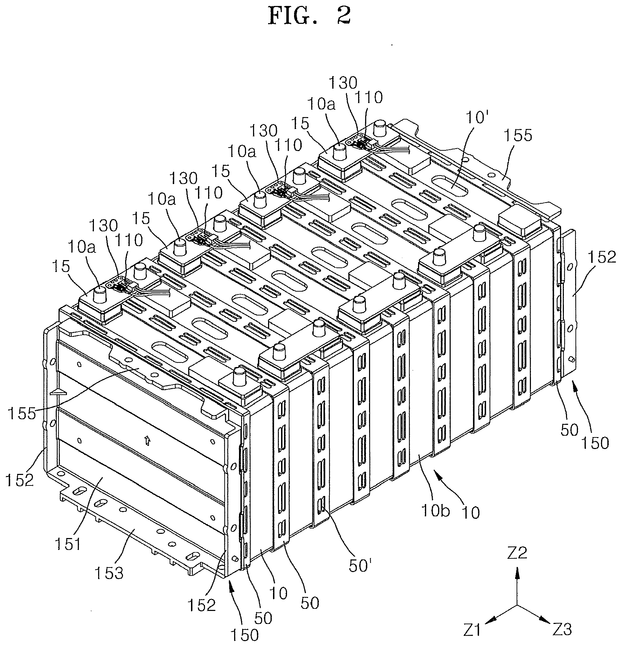

FIG. 2 illustrates a perspective view of the battery cells 10 in FIG. 1. Referring to FIGS. 1 and 2, the battery cells 10 may be secondary battery cells, e.g., lithium ion battery cells. The battery cells 10 may have any suitable shape, e.g., a cylindrical shape and a prismatic shape. In addition, the battery cells 10 may be any type of battery cells, e.g., polymer battery cells.

For example, each of the battery cells 10 may include a case 10b, an electrode assembly (not shown) disposed in the case 10b, and electrode terminals 10a electrically connected to the electrode assembly and exposed to the outside of the case 10b. For example, the electrode terminals 10a may be exposed to the outside of the case 10b and may form portions of the top side of the case 10b. Although not shown, the electrode assembly may include a positive electrode, a separator, and a negative electrode. The electrode assembly may be a jelly-roll or a stack type electrode assembly. The case 10b accommodates the electrode assembly, and the electrode terminals 10a are exposed to the outside of the case 10b for electric connection with an external circuit.

For example, neighboring battery cells 10 may be electrically connected to each other by connecting electrode terminals 10a of the neighboring battery cells 10. In detail, neighboring battery cells 10 may be electrically connected in series or parallel to each other by connecting electrode terminals 10a of the neighboring battery cells 10.

A safety vent 10' may be formed in the case 10b. The safety vent 10' is relatively weak so that if the inside pressure of the case 10b becomes equal to or higher than a preset critical value, the safety vent 10' may be fractured to release gas from the inside of the case 10b.

Spacers 50 may be disposed between neighboring battery cells 10. The spacers 50 may insulate the neighboring battery cells 10 from each other. For example, the cases 10b of the battery cells 10 may have electric polarities, and the spacers 50 formed of an insulation material and disposed between the cases 10b may prevent electric interference between neighboring pairs of the battery cells 10.

In addition, the spacers 50 may function as heat-dissipating paths between the battery cells 10. To this end, heat-dissipating holes 50' may be formed in the spacers 50. Heat-dissipating holes 140' (refer to FIG. 1) may be formed in the side plates 140 (described later). The heat-dissipating holes 140' of the side plates 140 may be aligned with the heat-dissipating holes 50' of the spacers 50 to form heat-dissipating paths between the battery cells 10.

The spacers 50 may be disposed between the battery cells 10 and prevent thermal expansion (swelling) of the battery cells 10. The cases 10b of the battery cells 10 are formed of a deformable, e.g., thermally expandable, material, e.g., metal. Thus, the spacers 50 may be formed of a less deformable, e.g., resilient, material, e.g., polymer, to suppress swelling of the battery cells 10.

The spacers 50 may be disposed on outermost sides of the battery cells 10 in the arrangement direction Z1 as well as between the battery cells 10. That is, as shown in FIG. 2, the end plates 150 may be disposed on both ends of the battery cells 10 in the arrangement direction Z1, and spacers 50 may be disposed between the end plates 150 and the outermost battery cells 10.

The end plates 150 may be provided as a pair on both ends of the battery cells 10 in the arrangement direction Z1 of the battery cells 10. Sides of the end plates 150 face outer sides of the battery cells 10. In detail, sides of the end plates 150 may face spacers 50 disposed on outer sides of the battery cells 10.

The end plates 150 combine the battery cells 10 as a unit. During charging and discharging of the battery cells 10, the end plates 150 prevent expansion of the battery cells 10 and maintain resistance characteristics of the battery cells 10. Therefore, electric characteristics of the battery cells 10 may be preserved.

Each of the end plates 150 may include a base plate 151, and flanges 152, 153, and 155 bent from the base plate 151 in a direction opposite to the battery cells 10. The base plate 151 may have a sufficient area to cover a corresponding side of the battery cells 10.

The flanges 152, 153, and 155 are bent from edges of the base plate 151 in a direction opposite to the battery cells 10. The flanges 152 may be a pair of lateral flanges 152 formed on both lateral sides of the base plate 151, and the flanges 153 and 155 may respectively be upper and lower flanges 153 and 155 formed on upper and lower sides of the base plate 151.

Referring to FIG. 1, the flanges 152, 153, and 155 of the end plates 150 may be coupling positions at which neighboring elements are coupled to the end plates 150. For example, the flanges 152 and 153 of the end plates 150 may be coupled to edge portions of the side plates 140. In addition, the flanges 152, 153, and 155 may enhance the mechanical stiffness of the end plates 150.

The lateral flanges 152 of the end plates 150 may be coupling positions at which the side plates 140 are coupled to the end plates 150. For example, the side plates 140 may be coupled to the end plates 150 by placing end portions of the side plates 140 on the lateral flanges 152 and fastening the edge portions of the side plates 140 and the lateral flanges 152 using screws. For this, a plurality of coupling holes may be formed in the lateral flanges 152.

The side plates 140 may be disposed on both lateral sides of the battery cells 10. In other words, the side plates 140 may cover both lateral sides of the battery cells 10 arranged in the arrangement direction Z1. The side plates 140 may be provided as a pair on opposite lateral sides of the battery cells 10. The side plates 140 may extend in the arrangement direction Z1 of the battery cells 10. Ends of the side plates 140 may be coupled to the end plates 150 disposed on opposite ends of the battery cells 10. The side plates 140 may be coupled to the lateral flanges 152 formed on lateral edges of the end plates 150 by placing the lateral flanges 152 on the side plates 140, aligning coupling holes of the lateral flanges 152 and the side plates 140, and fastening the lateral flanges 152 and the side plates 140 using fasteners 171, e.g., bolts and nuts. At this time, at least portions of the side plates 140 and the lateral flanges 152 may be in surface contact with each other.

The side plates 140 may have a plate shape. The side plates 140 may have catch jaws 140a to support portions of the bottom sides of the battery cells 10. The side plates 140 may be disposed on the opposite lateral sides of the battery cells 10, and the catch jaws 140a may be bent from the side plates 140 to face each other and support the bottom sides of the battery cells 10.

The catch jaws 140a may extend along the entire lengths of the side plates 140 in the arrangement direction Z1 of the battery cells 10, and end portions of the catch jaws 140a may be coupled to the lower flanges 153 of the end plates 150 using screws. To this end, coupling holes may be formed in the catch jaws 140a and the lower flanges 153. For example, the side plates 140 and the end plates 150 may be coupled by aligning the coupling holes of the catch jaws 140a and the lower flanges 153, and inserting the fasteners 171 into the coupling holes and tightening the fasteners 171. The catch jaws 140a and the lower flanges 153 may make surface contact with each other at corners of the battery pack. In this way, the side plates 140 may be fastened to the lower flange 153 and the lateral flanges 152 of the end plates 150 to form an accommodation space for receiving the battery cells 10.

The heat-dissipating holes 140' may be formed in the side plates 140. For example, the heat-dissipating holes 140' may be formed at regular intervals in the arrangement direction Z1 of the battery cells 10. Air may flow to the battery cells 10 through the heat-dissipating holes 140', and thus heat may be rapidly dissipated from the battery cells 10 during operation of the battery cells 10.

The bottom sides of the battery cells 10 may be exposed except for the portions supported by the catch jaws 140a of the side plates 140. Thus, air may flow between the battery cells 10 through the bottom sides of the battery cells 10 to cool the battery cells 10.

Boss members 145 may be formed on the side plates 140 to attach a circuit board (not shown) to the boss members 145. For example, the circuit board may be a BMS board. For example, first surfaces of the side plates 140 may face the battery cells 10, and the circuit boards may be attached to second, e.g., outer, surfaces of the side plates 140. For example, the circuit board may monitor and control charging and discharging of the battery cells 10.

For example, the boss members 145 may be disposed at four positions corresponding to the rectangular or square shape of the circuit board. In another example, the number of boss members 145 may be multiples of four, and a plurality of circuit boards may be attached to the boss members 145. The circuit boards may have coupling holes (not shown), and screws may be inserted in the coupling holes of the circuit boards and the boss members 145 of the side plates 140 to fix the circuit boards to the side plates 140.

The battery cells 10 forming the battery pack may be electrically connected to each other through the bus bars 15. For example, the battery cells 10 may be electrically connected in series. Each of the bus bars 15 may electrically connect a pair of the battery cells 10. The electrode terminals 10a of the battery cells 10 may be inserted into or welded to the bus bars 15. The bus bars 15 may be disposed on the left and right sides when viewed in the directions ±Z3, so as to sequentially connect the battery cells 10 arranged in the arrangement direction Z1.

The wires 85 and 95 of the battery pack may extend from the bus bars 15. For example, the wires 85 and 95 may extend to transmit information about measured voltages and temperatures of the battery cells 10 to a BMS. For example, first ends of the wires 85 and 95 may be connected to the connectors 130 formed on the bus bars 15, and second ends of the wires 85 and 95 may be connected to the BMS.

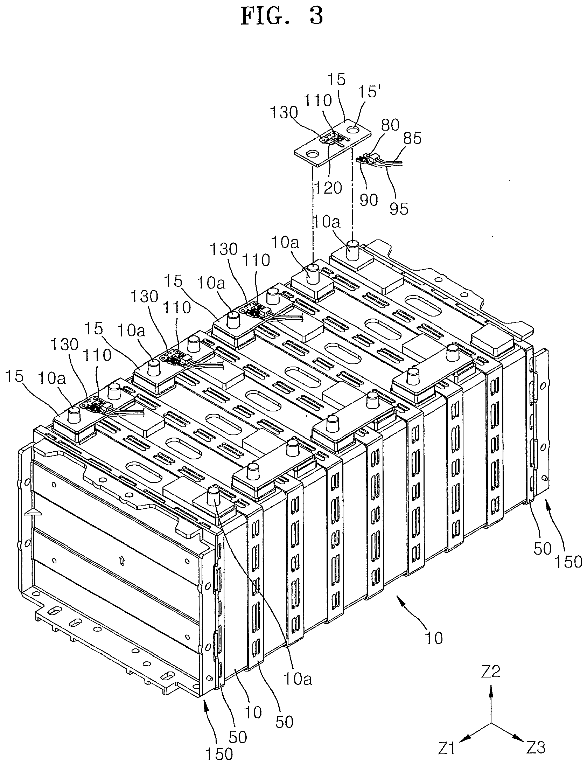

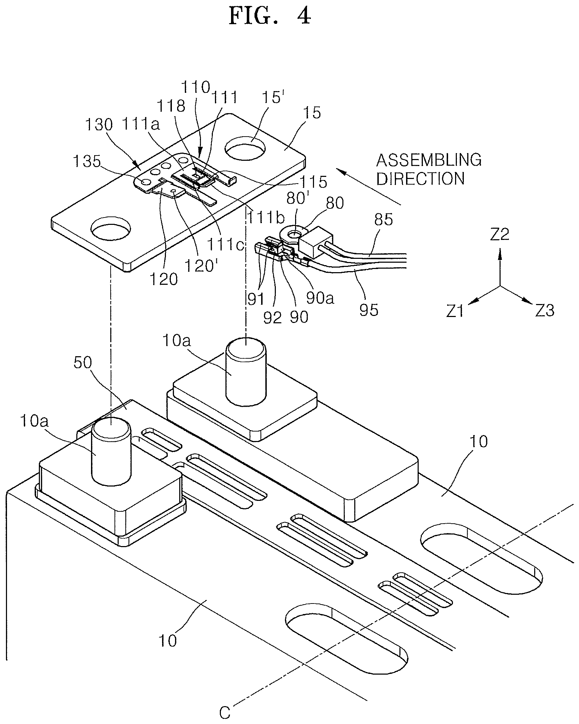

FIG. 3 illustrates a view of a connection of the first and second sensing terminals 80 and 90 to the battery cells 10 to measure temperatures and voltages of the battery cells 10. FIG. 4 illustrates an enlarged, partial view of FIG. 3.

According to embodiments of the invention, in a monitoring mode, the battery pack may collect information, e.g., temperatures and voltages of the battery cells 10, so as to detect abnormal operations of the battery cells 10, e.g., overheating, over-current, overcharging, and over-discharging, and to control charging and discharging of the battery cells 10. The battery pack may include the wires 85 and 95 extending from the battery cells 10 to transmit such information about the battery cells 10.

In detail, the wires 85 and 95 may include the temperature measuring wires 85 and the voltage measuring wires 95 to transmit temperature signals and voltage signals, respectively. The first and second sensing terminals 80 and 90 forming, e.g., defining, ends of the temperature measuring wires 85 and the voltage measuring wires 95 may be respectively connected to the connectors 130 formed on the bus bars 15.

The connectors 130 may accommodate both the first and second sensing terminals 80 and 90 of the temperature measuring wires 85 and the voltage measuring wires 95, and may fix the positions of the first and second sensing terminals 80 and 90 on the bus bars 15. That is, the connectors 130 may function as temperature and voltage measuring positions.

The connectors 130, e.g., each connector 130, may have a plate shape extending in parallel to the bus bars 15. The connectors 130 may include first and second connection parts 110 and 120 for connection with the first and second sensing terminals 80 and 90, respectively. Since the connectors 130 function as contact points to which the first and second sensing terminals 80 and 90 are connected to measure temperatures and voltages, after the connectors 130 are formed on the bus bars 15 through a single process, the first and second sensing terminals 80 and 90 may be simply connected.

In detail, once the connectors 130 are formed on the bus bars 15, the first and second sensing terminals 80 and 90 may be easily connected through simple insertions. That is, since the first and second sensing terminals 80 and 90 have sliding-in structures for insertion into the first and second connection parts 110 and 120, the first and second sensing terminals 80 and 90 may be smoothly connected to the first and second connection parts 110 and 120 of the connectors 130, respectively, during an assembling process.

Referring to FIG. 3, the number of first and second sensing terminals 80 and 90 may be determined based on the number of temperature measuring points and the number of voltage measuring points. For example, temperatures and voltages may be measured from all the battery cells 10, a pair of the battery cells 10, or a predetermined number of the battery cells 10 of the battery pack, etc., so as to monitor temperatures and voltages of the battery cells 10 at desired points. Referring to FIG. 4, terminal holes 15' are formed in the bus bar 15 to receive the electrode terminals 10a of the battery cells 10.

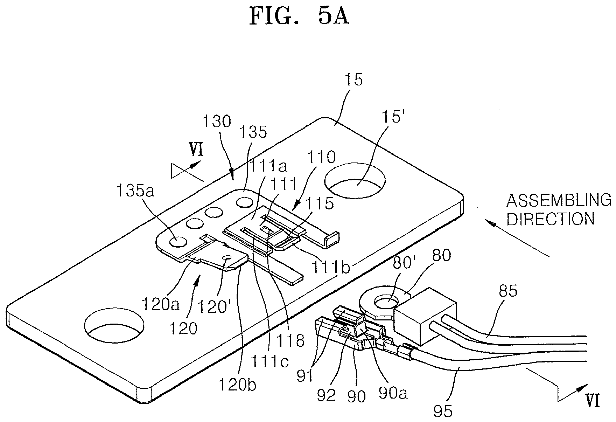

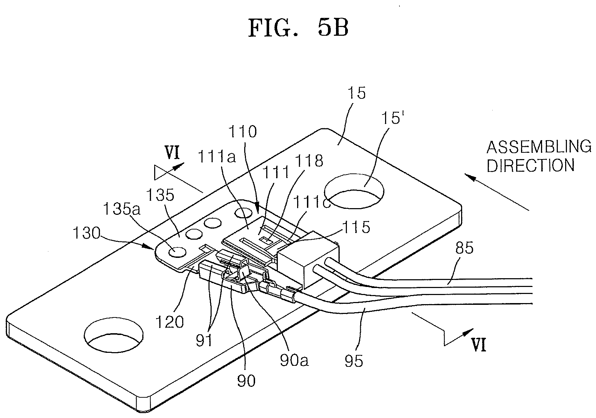

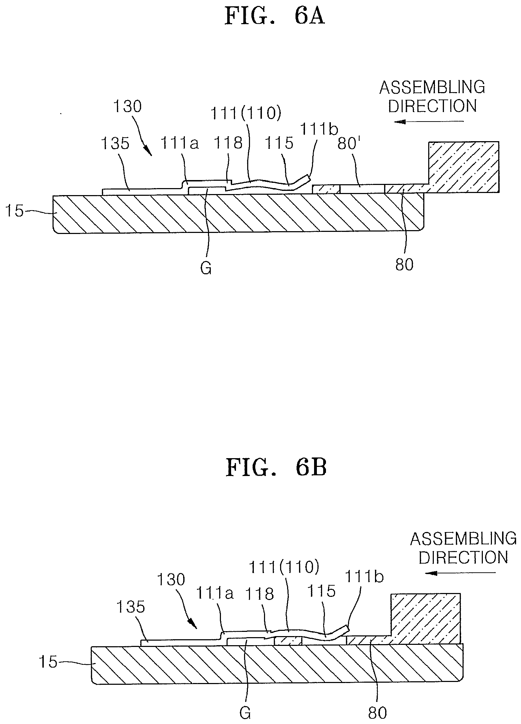

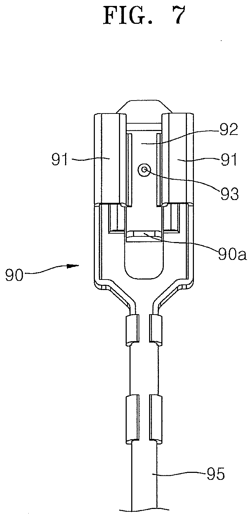

FIGS. 5A and 5B illustrate perspective enlarged views of a connection between the connector 130 and the first and second sensing terminals 80 and 90. FIGS. 6A and 6B illustrate cross-sectional views taken along lines VI-VI of FIGS. 5A and 5B, respectively. FIG. 7 illustrates a plan view of the second sensing terminal 90.

Referring to FIGS. 5A to 7, the connector 130 may be disposed on the bus bar 15 and may have a plate shape extending in parallel with the bus bar 15. In detail, the connector 130 may include a coupling part 135, and the coupling part 135 may be coupled to the bus bar 15. For example, an area of the coupling part 135 making contact with the bus bar 15 may be sufficiently large for stable coupling between the coupling part 135 and the bus bar 15. For example, the coupling part 135 may include a plurality of coupling points 135a, and the connector 130 and the bus bar 15 may be coupled to each other by superimposing the connector 130 on the bus bar 15 and partially deforming the coupling points 135a of the connector 130 and the bus bar 15 through a process, e.g., riveting or TOX joining.

The coupling part 135 may be disposed on an outer side of the connector 130, and the first and second connection parts 110 and 120 may be disposed on an inner side of the coupling part 135 to receive the first and second sensing terminals 80 and 90. Referring to FIG. 4, the outer side of the connector 130 refers to a side relatively distant from a center line C of the battery cells 10, and an inner side of the connector 130 refers to a side relatively close to the center line C of the battery cells 10. For example, as illustrated in FIG. 4, the first and second connection parts 110 and 120 may be adjacent to each other along the Z1 direction, and may be between the coupling part 135 and the center line C along the Z3 direction.

The coupling part 135 and the first and second connection parts 110 and 120 of the connector 130 may be formed in one piece, e.g., integral with each other as a single and seamless unit. For example, the connector 130 may have a plate shape, and the coupling part 135 and the first and second connection parts 110 and 120 of the connector 130 may be formed in one piece by processing a metal sheet through a process, e.g., cutting, bending, and drawing. In another example, the connector 130 may be formed of a stack of at least two metal sheets. In this case, the metal sheets of the connector 130 may be firmly coupled, and thus the metal sheets may not be separated from each other without deforming or cutting the metal sheets.

For example, the connector 130 may be formed of a corrosion-resistant metal, e.g., brass, thin-coated steel, stainless steel (SUS), nickel, and spring steel. The connector 130 formed of such a corrosion-resistant metal may be coupled to the bus bar 15 formed of aluminum or copper through a coupling process, e.g., riveting or TOX joining.

Referring to FIGS. 6A and 6B, the first connection part 110 may protrude upward relative to the coupling part 135, and may form, e.g., define, an accommodation space G together with the bus bar 15 to receive the first sensing terminal 80. In other words, the first connection part 110 may form the accommodation space G to receive at least a portion of the first sensing terminal 80. The first sensing terminal 80 may be inserted into the accommodation space G between the first connection part 110 and the bus bar 15, e.g., the first sensing terminal 80 may be a loop connected to a pair of wires 85.

In detail, the accommodation space G is formed between the bus bar 15 and the first connection part 110 including a fixed end 111a. That is, the first connection part 110 includes the fixed end 111a attached to the coupling part 135, and a free end 111b opposite the fixed end 111a. For example, the free end 111b may be suspended above the bus bar (FIG. 6A), and may be movable, e.g., upward, to fit the first sensing terminal 80 between a lower surface of the first connection part 110 and the bus bar 15 (FIG. 6B), i.e., in the accommodation space G. In other words, the accommodation space G may be between an open end, i.e., the free end 111b, to receive the first sensing terminal 80, and an opposite closed end, i.e., the fixed end 111a, of the first connection part 110.

The first connection part 110 may include a cantilever member 111. The cantilever member 111 may include the fixed end 111a connected to the coupling part 135, and the free end 111b that is opposite to the fixed end 111a, i.e., not connected directly to the coupling part 135. In other words, the fixed end 111a of the cantilever member 111 may be connected to the coupling part 135 of the connector 130, and the free end 111b of the cantilever member 111 may be located opposite to the fixed end 111a and not connected directly to the coupling part 135 of the connector 130.

During assembling, the first sensing terminal 80 may slide toward the fixed end 111a of the cantilever member 111, while pushing the free end 111b of the cantilever member 111 upward. As a result, the first connection part 110 may be assembled under the cantilever member 111. At this time, the cantilever member 111 is elastically deformed by the first sensing terminal 80, and thus the first sensing terminal 80 is pressed against the top side of the bus bar 15 by the resilience of the cantilever member 111.

The cantilever member 111 may include a pressing part 115 protruding toward the bus bar 15. The pressing part 115 may protrude downward toward the bus bar 15. The pressing part 115 may be formed at a position between the free end 111b and the fixed end 111a, and when the first sensing terminal 80 is slid in an assembling direction, the pressing part 115 may be inserted into an assembling hole 80' of the first sensing terminal 80 to prevent the first sensing terminal 80 from being freely separated, e.g., removed, from the first connection part 110 (FIG. 6B). For example, the pressing part 115 may be closer to the free end 111b than the fixed end 111a.

Referring to FIGS. 5A and 5B, slots 111c may be formed in the first connection part 110 along both sides of the cantilever member 111 to separate the cantilever member 111 from other portions of the first connection part 110, e.g., the pressing part 115 may be between the slots 111c. Therefore, the slots 111c enable the pressing part 115 of the cantilever member 111 to freely undergo elastic deformation, and thus the first sensing terminal 80 may be effectively pressed and fixed by the pressing part 115. Since the first sensing terminal 80 is pressed against the bus bar 15 by the pressing part 115, the temperature of the bus bar 15 may be precisely measured.

A pressure adjusting part 118 may be formed on the cantilever member 111. The pressure adjusting part 118 may adjust a pressing force applied to the first sensing terminal 80 by the pressing part 115. For example, the pressure adjusting part 118 may protrude downward toward the bus bar 15. Referring to FIGS. 6A and 6B, the pressure adjusting part 118 may have a stepped shape protruding downward toward the bus bar 15. For example, the downwardly stepped shape of the pressure adjusting part 118 may increase a pressing force of the pressing part 115 on the first sensing terminal 80. In another example, the pressure adjusting part may have a shape protruding upwardly in a direction opposite to the bus bar 15, thereby reducing an overall pressing force directed from the pressing part 115 toward the first sensing terminal 80, e.g., so the free end 111b of the first connection part 110 may not be closed. Therefore, a sliding-in motion of the first sensing terminal 80 may not be blocked.

The pressure adjusting part 118 may be formed at a position between the fixed end 111a and the free end 111b of the cantilever member 111. The pressure adjusting part 118 may be formed at a plurality of positions. For example, the pressure adjusting part 118 may be closer to the fixed end 111a than to the free end 111b.

Referring to FIG. 5A, the second connection part 120 may include a fixed end 120a connected to the coupling part 135 and a free end 120b opposite to the fixed end 120a, e.g., not connected directly to the coupling part 135. The second connection part 120 may protrude from a side of the connector 130. For example, the second connection part 120 may extend in an oblique direction with respect to the bus bar 15, so that a distance between the second connection part 120 and the bus bar 15 may increase in a direction from the fixed end 120a to the free end 120b of the second connection part 120. That is, the second connection part 120 may protrude upwardly in an oblique direction from the connector 130. Thus, the free end 120b of the second connection part 120 may be located above, e.g., at a predetermined distance other than zero from, the connector 130 to easily receive the second sensing terminal 90.

A coupling structure may be formed to securely maintain the positions of the second connection part 120 and the second sensing terminal 90, after the second connection part 120 and the second sensing terminal 90 are assembled by sliding. For example, as shown in FIGS. 5A, an assembling hole 120' may be formed in the second connection part 120 to receive a protrusion 93 (FIG. 7) of the second sensing terminal 90. For example, the protrusion 93 formed on the second sensing terminal 90 may be inserted into the assembling hole 120' of the second connection part 120 for securing connection between the second sensing terminal 90 and the second connection part 120.

In detail, referring to FIGS. 5A and 7, the second sensing terminal 90 may include guide rails 91 capable of receiving edges of the second connection part 120 for guiding sliding-in assembling of the second sensing terminal 90 to the second connection part 120. For example, the second sensing terminal 90 may include a pair of parallel guide rails 91 extending along both lateral edges of the second sensing terminal 90 in the protruding direction of the second connection part 120. The protrusion 93 may be formed between the guide rails 91. The protrusion 93 may be slid in an elastically compressed state along the second connection part 120 inserted in the guide rails 91 and may be inserted into the assembling hole 120'. After the protrusion 93 is inserted into the assembling hole 120', sliding of the second sensing terminal 90 is stopped, and the second sensing terminal 90 is not freely separated.

For example, the protrusion 93 may be formed on a pressing plate 92 between the guide rails 91, and a catch jaw 90a may be formed on an end of the pressing plate 92 so as to stop a forward movement of the second connection part 120 and determine a coupling position. For example, when the protrusion 93 of the second sensing terminal 90 is coupled to the assembling hole 120' of the second connection part 120, the catch jaw 90a of the second sensing terminal 90 may make contact with an end of the second connection part 120 (FIG. 5B). In this way, the coupling position of the second sensing terminal 90 may be determined.

The first and second sensing terminals 80 and 90 may make conductive contact with the first and second connection parts 110 and 120 of the connector 130. For example, the first sensing terminal 80 may be brought into thermal and conductive contact with the first connection part 110 of the connector 130 to measure the temperature of the battery cells 10 through the first connection part 110. For example, the first sensing terminal 80 may be pressed against the top side of the bus bar 15 by the pressing part 115 of the first connection part 110. Since the electrode terminals 10a of the battery cells 10 are connected to the bus bar 15, the temperature of the battery cells 10 may be precisely measured through the first sensing terminal 80.

Temperature information of a measuring point may be converted into an electric signal and transmitted to a BMS through the first sensing terminal 80. In detail, the first sensing terminal 80 may be connected to a resistance temperature sensor having a temperature-dependent variable electric resistance to generate a voltage signal corresponding to a measured temperature.

The second sensing terminal 90 may make electrically conductive contact with the second connection part 120 of the connector 130. For example, the second sensing terminal 90 may be used to measure the voltage of the bus bar 15 through the second connection part 120 of the connector 130. That is, the second sensing terminal 90 may be used to measure a common terminal voltage of the battery cells 10 electrically connected through the bus bar 15.

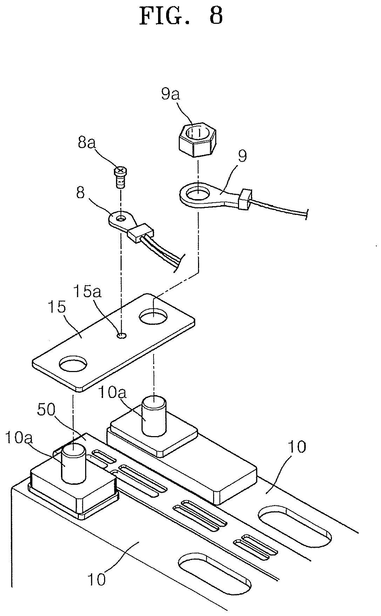

FIG. 8 illustrates a view of a comparative example of connection structures of first and second sensing terminals 8 and 9. Referring to FIG. 8, the first sensing terminal 8 and the second sensing terminal 9 are connected to positions adjacent to battery cells 10 to measure temperature and voltage, respectively. The first sensing terminal 8 may be connected to the bus bar 15 by using a screw 8a. In this case, however, a threaded hole 15a may be formed in the bus bar 15 through an additional threading process having a low level of processing efficiency. In addition, errors such as an insufficient coupling force or a connection omission may easily occur.

The second sensing terminal 9 for measuring voltage may be placed around electrode terminals 10a of the battery cells 10, and may be fixed by screwing a nut 9a onto the electrode terminals 10a. In the comparative example, the first sensing terminal 8 for measuring temperature and the second sensing terminal 9 for measuring voltage are individually connected using the screw 8a and the nut 9a. Therefore, the efficiency of the connection process is low, and connection errors may easily occur.

However, in exemplary embodiments, after the connector 130 is mounted on the bus bar 15, the first and second sensing terminals 80 and 90 are easily connected through simple insertions. In other words, as described above, both the first and second sensing terminals 80 and 90 for measuring temperature and voltage are connected to the connector 130 via a simple structure. That is, after the connector 130 is mounted through a single process, the first and second sensing terminals 80 and 90 may be simply and easily connected to the connector 130 through simple insertions.

Example embodiments have been disclosed herein, and although specific terms are employed, they are used and are to be interpreted in a generic and descriptive sense only and not for purpose of limitation. Accordingly, it will be understood by those of skill in the art that various changes in form and details may be made without departing from the scope of the present invention as set forth in the following claims.

## Claims

1. A battery pack, comprising:
a first battery cell and a second battery cell;
a bus bar that electrically connects the first battery cell and the second battery cell;
a connector that is formed on the bus bar and includes first and second connection parts; and
first and second sensing terminals connected to the first and second connection parts, respectively, the first and second sensing terminals being configured to measure a temperature and a voltage of the battery cell, respectively;
wherein the first and second sensing terminals are slidable relative to the first and second connection parts, respectively, and
the first connection part is configured to press the first sensing terminal against the bus bar.

2. A battery pack according to claim 1, wherein the first and second connection parts are integral with each other.

3. A battery pack as claimed in claim 1 or 2, wherein the connector further comprises a coupling part coupled to the bus bar.

4. A battery pack as claimed in of claim 3, wherein the coupling part and the first and second connection parts are integral with each other.

5. A battery pack as claimed in claim 3 or 4, wherein the coupling part is at an outer side of the bus bar, and the first and second connection parts are at an inner side of the bus bar, the inner side of the bus bar being between the outer side of the bus bar and a center line of the battery cells.

6. A battery pack as claimed in any preceding claim, wherein the first connection part defines an accommodation space together with the bus bar to receive the first sensing terminal.

7. A battery pack as claimed in any preceding claim, wherein the first connection part includes a cantilever member having a fixed end connected to the coupling part and an opposite free end.

8. A battery pack as claimed in claim 7, wherein the first connection part further comprises slots along two sides of the cantilever member, the slots separating the cantilever member from other portions of the first connection part.

9. A battery pack as claimed in claim 7 or 8, wherein the first sensing terminal is slidable between the cantilever member and the bus bar via the free end toward the fixed end.

10. A battery pack as claimed in one of claims 7 to 9, wherein the cantilever member includes a pressing part protruding toward the bus bar, the pressing member being adapted to press against the first sensing terminal upon insertion of the first sensing terminal into the first connection part.

11. A battery pack as claimed in claim 10, wherein the pressing part is closer to the free end than to the fixed end.

12. A battery pack as claimed in one of claims 7 to 11, wherein the cantilever member includes a pressure adjusting part protruding toward the bus bar.

13. A battery pack as claimed in claim 12 wherein the pressure adjusting part has a stepped shape facing the bus bar.

14. A battery pack as claimed in claim 3 or any claim dependent upon claim 3, wherein the second connection part includes a fixed end connected to the coupling part and an opposite free end.

15. A battery pack as claimed in claim 14, wherein the second connection part extends in an oblique direction relative to the bus bar, a distance between the second connection part and the bus bar increasing in a direction from the fixed end to the free end of the second connection part.

16. A battery pack as claimed in claim 14, wherein the second connection part includes an assembling hole, a protrusion of the second sensing terminal being inserted into the assembling hole.

17. A battery pack as claimed in claim 16, wherein the second sensing terminal includes a pair of guide rails configured to accommodate edges of the second connection part, the protrusion being on a pressing plate between the guide rails.

18. A battery pack as claimed in claim 17, wherein the second sensing terminal further comprises a catch jaw at an end of the pressing plate, the catch jaw being configured to align with an assembling position of the second connection part.

## Patentansprüche

1. Batteriepaket, das Folgendes umfasst:
eine erste Batteriezelle und eine zweite Batteriezelle,
eine Sammelschiene, welche die erste Batteriezelle und die zweite Batteriezelle elektrisch verbindet,
einen Verbinder, der an der Sammelschiene geformt ist und einen ersten und einen zweiten Verbindungsteil einschließt, und
einen ersten und einen zweiten Sensoranschluss, die jeweils mit dem ersten beziehungsweise dem zweiten Verbindungsteil verbunden sind, wobei der erste und der zweite Sensoranschluss dafür konfiguriert sind, jeweils eine Temperatur und eine Spannung der Batteriezelle zu messen,
wobei der erste und der zweite Sensoranschluss jeweils im Verhältnis zu dem ersten beziehungsweise dem zweiten Verbindungsteil verschiebbar sind und
der erste Verbindungsteil dafür konfiguriert ist, den ersten Sensoranschluss gegen die Sammelschiene zu pressen.

2. Batteriepaket nach Anspruch 1, wobei der erste und der zweite Verbindungsteil miteinander integriert sind.

3. Batteriepaket nach Anspruch 1 oder 2, wobei der Verbinder ferner einen Kupplungsteil umfasst, der an die Sammelschiene gekoppelt ist.

4. Batteriepaket nach Anspruch 3, wobei der Kupplungsteil und der erste und der zweite Verbindungsteil miteinander integriert sind.

5. Batteriepaket nach Anspruch 3 oder 4, wobei sich der Kupplungsteil an einer äußeren Seite der Sammelschiene befindet und sich der erste und der zweite Verbindungsteil an einer inneren Seite der Sammelschiene befinden, wobei sich die innere Seite der Sammelschiene zwischen der äußeren Seite der Sammelschiene und einer Mittellinie der Batteriezellen befindet.

6. Batteriepaket nach einem der vorhergehenden Ansprüche, wobei der erste Verbindungsteil zusammen mit der Sammelschiene einen Aufnahmeraum bildet, um den ersten Sensoranschluss aufzunehmen.

7. Batteriepaket nach einem der vorhergehenden Ansprüche, wobei der erste Verbindungsteil ein Auslegerelement einschließt, das ein fixiertes Ende, das mit dem Kupplungsteil verbunden ist, und ein entgegengesetztes freies Ende aufweist.

8. Batteriepaket nach Anspruch 7, wobei der erste Verbindungsteil ferner Schlitze entlang von zwei Seiten des Auslegerelements umfasst, wobei die Schlitze das Auslegerelement von anderen Abschnitten des ersten Verbindungsteils trennen.

9. Batteriepaket nach Anspruch 7 oder 8, wobei der erste Sensoranschluss zwischen dem Auslegerelement und der Sammelschiene über das freie Ende und zu dem fixierten Ende hin verschiebbar ist.

10. Batteriepaket nach einem der Ansprüche 7 bis 9, wobei das Auslegerelement einen Pressteil einschließt, der zu der Sammelschiene hin vorspringt, wobei das Presselement angepasst ist, um auf ein Einsetzen des ersten Sensoranschlusses in den ersten Verbindungsteil hin gegen den ersten Sensoranschluss zu pressen.

11. Batteriepaket nach Anspruch 10, wobei der Pressteil dem freien Ende näher ist als dem fixierten Ende.

12. Batteriepaket nach einem der Ansprüche 7 bis 11, wobei das Auslegerelement einen Druckeinstellungsteil einschließt, der zu der Sammelschiene hin vorspringt.

13. Batteriepaket nach Anspruch 12, wobei der Druckeinstellungsteil eine abgestufte Seite aufweist, die zu der Sammelschiene zeigt.

14. Batteriepaket nach Anspruch 3 oder einem von Anspruch 3 abhängigen Anspruch, wobei der zweite Verbindungsteil ein fixiertes Ende, das mit dem Kupplungsteil verbunden ist, und ein entgegengesetztes freies Ende einschließt.

15. Batteriepaket nach Anspruch 14, wobei sich der zweite Verbindungsteil in einer schrägen Richtung im Verhältnis zu der Sammelschiene erstreckt, wobei eine Entfernung zwischen dem zweiten Verbindungsteil und der Sammelschiene in einer Richtung von dem fixierten Ende zu dem freien Ende des zweiten Verbindungsteils zunimmt.

16. Batteriepaket nach Anspruch 14, wobei der zweite Verbindungsteil ein Montageloch einschließt, wobei ein Vorsprung des zweiten Sensoranschlusses in das Montageloch eingesetzt ist.

17. Batteriepaket nach Anspruch 16, wobei der zweite Sensoranschluss ein Paar von Führungsschienen aufweist, die dafür konfiguriert sind, Kanten des zweiten Verbindungsteils aufzunehmen, wobei sich der Vorsprung auf einer Pressplatte zwischen den Führungsschienen befindet.

18. Batteriepaket nach Anspruch 17, wobei der zweite Sensoranschluss ferner eine Fangklaue an einem Ende der Pressplatte umfasst, wobei die Fangklaue dafür konfiguriert ist, sich mit einer Anbringungsposition des zweiten Verbindungsteils auszurichten.

## Revendications

1. Bloc-batteries, comprenant :
un premier élément de batterie et un second élément de batterie ;
une barre de bus qui relie électriquement le premier élément de batterie et le second élément de batterie ;
un connecteur qui est formé sur la barre de bus et inclut une première et une seconde partie de connexion ; et
une première et une seconde borne de détection connectées à la première et à la seconde partie de connexion, respectivement, la première et la seconde borne de détection étant configurées afin de mesurer une température et une tension de l'élément de batterie, respectivement ;
dans lequel la première et la seconde borne de détection peuvent coulisser relativement à la première et à la seconde partie de connexion, respectivement, et
la première partie de détection est configurée afin de comprimer la première borne de détection contre la barre de bus.

2. Bloc-batteries selon la revendication 1, dans lequel la première et la seconde partie de connexion sont d'un seul tenant l'une avec l'autre.

3. Bloc-batteries selon la revendication 1 ou 2, dans lequel le connecteur comprend en outre une partie de connexion raccordée à la barre de bus.

4. Bloc-batteries selon la revendication 3, dans lequel la partie de connexion et la première et la seconde partie de connexion sont d'un seul tenant l'une avec l'autre.

5. Bloc-batteries selon la revendication 3 ou 4, dans lequel la partie de connexion est sur un côté extérieur de la barre de bus, et la première et la seconde partie de connexion sont sur un côté intérieur de la barre de bus, le côté intérieur de la barre de bus étant entre le côté extérieur de la barre de bus et une ligne centrale des éléments de batterie.

6. Bloc-batteries selon l'une quelconque des revendications précédentes, dans lequel la première partie de connexion définit un espace de logement avec la barre de bus permettant de recevoir la première borne de détection.

7. Bloc-batteries selon l'une quelconque des revendications précédentes, dans lequel la première partie de connexion inclut un élément en porte-à-faux présentant une extrémité fixe raccordée à la partie de connexion et à une extrémité libre opposée.

8. Bloc-batteries selon la revendication 7, dans lequel la première partie de connexion comprend en outre des fentes le long de deux côtés de l'élément en porte-à-faux, les fentes séparant l'élément en porte-à-faux des autres parties de la première partie de connexion.

9. Bloc-batteries selon la revendication 7 ou 8, dans lequel la première borne de détection peut coulisser entre l'élément en porte-à-faux et la barre de bus via l'extrémité libre vers l'extrémité fixe.

10. Bloc-batteries selon l'une quelconque des revendications 7 à 9, dans lequel l'élément en porte-à-faux inclut une partie de compression saillant vers la barre de bus, l'élément de compression étant conçu afin de se comprimer contre la première borne de détection lors de l'insertion de la première borne de détection dans la première partie de connexion.

11. Bloc-batteries selon la revendication 10, dans lequel la partie de compression est plus proche de l'extrémité libre que de l'extrémité fixe.

12. Bloc-batteries selon l'une des revendications 7 à 11, dans lequel l'élément en porte-à-faux inclut une partie d'ajustage de pression saillant vers la barre de bus.

13. Bloc-batteries selon la revendication 12, dans lequel la partie d'ajustage de pression présente une forme étagée orientée vers la barre de bus.

14. Bloc-batteries selon la revendication 3 ou toute revendication dépendante de la revendication 3, dans lequel la seconde partie de connexion inclut une extrémité fixe raccordée à la partie de connexion et une extrémité libre opposée.

15. Bloc-batteries selon la revendication 14, dans lequel la seconde partie de connexion s'étend dans une direction oblique relativement à la barre de bus, une distance entre la seconde partie de connexion et la barre de bus augmentant dans une direction de l'extrémité fixe à l'extrémité libre de la seconde partie de connexion.

16. Bloc-batteries selon la revendication 14, dans lequel la seconde partie de connexion inclut un trou d'assemblage, une saillie de la seconde borne de détection étant insérée dans le trou d'assemblage.

17. Bloc-batteries selon la revendication 16, dans lequel la seconde borne de détection inclut une paire de rails de guidage configurés afin de recevoir des bords de la seconde partie de connexion, la saillie étant sur une plaque de compression entre les rails de guidage.

18. Bloc-batteries selon la revendication 17, dans lequel la seconde borne de détection comprend en outre une mâchoire de prise à une extrémité de la plaque de compression, la mâchoire de prise étant configurée afin de s'aligner avec une position d'assemblage de la seconde partie de connexion.
